(19) Europäisches Patentamt

European Patent Office

Office européen des brevets

(11) **EP 4 209 781 A1**

(12) **EUROPEAN PATENT APPLICATION**

(43) Date of publication:
**12.07.2023 Bulletin 2023/28**

(21) Application number: **22150763.5**

(22) Date of filing: **10.01.2022**

(51) International Patent Classification (IPC):
**G01N 25/00** *(2006.01)*

(52) Cooperative Patent Classification (CPC):
**G01N 25/00**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Mettler-Toledo GmbH
8606 Greifensee (CH)**

(72) Inventors:
• **Wüst, Urs
  8634 Hombrechtikon (CH)**
• **Jörimann, Urs
  8614 Bertschikon (CH)**
• **Höchemer, Matthias
  6072 Sachseln (CH)**
• **Schöpe, Till
  6004 Luzern (CH)**
• **Kastanis, Iason
  8105 Watt (CH)**
• **Bendinelli, Tommaso
  6063 Stadeln (CH)**
• **Beyer, Christian
  4600 Olten (CH)**

(74) Representative: **Mettler-Toledo
IP Department
Im Langacher 44
8606 Greifensee (CH)**

(54) **COMPUTER-IMPLEMENTED METHOD, SYSTEM AND COMPUTER PROGRAM FOR THERMAL ANALYSIS OF A SAMPLE OF A SUBSTANCE**

(57) The present invention is related to a computer-implemented method for thermal analysis of a sample of a substance, said method comprising: providing first data to a first software module (6), said first data representing an observable response signal of said sample subjected to an excitation which generates an observable response and said excitation as a function of time, said response signal being representative of a thermal effect due to said sample, said first software module (6) being configured to receive said first data as an input, to calculate a thermoanalytical measurement curve from the first data, said thermoanalytical measurement curve allowing the identification of said thermal effect and to output second data suitable for representing said measurement curve wherein the method further comprises providing said second data to a second software module, said second software module comprising an artificial intelligence engine (9) configured for automatic identification of thermal effects, said second software module being configured to receive said second data as an input and to output third data representative of said thermal effect automatically identified by said artificial intelligence engine (9).

Fig. 3b

EP 4 209 781 A1

## Description

The present invention is related to a computer-implemented method for thermal analysis of a sample of a substance, said method comprising: providing first data to a first software module, said first data representing an observable response signal of said sample subjected to an excitation which generates an observable response and said excitation as a function of time, said response signal being representative of a thermal effect due to said sample, said first software module being configured to receive said first data as an input, to calculate a thermoanalytical measurement curve from said first data, said thermoanalytical measurement curve allowing the identification of said thermal effect, and to output second data suitable for representing said measurement curve. Furthermore, the present invention is related to a system for thermal analysis of a sample of a substance, to a computer program for thermal analysis of a sample of a substance, to a training software module of a computer program for thermal analysis and to a computer-readable data carrier having stored thereon said computer program.

Thermal analysis studies physical and chemical properties of a substance as they change with temperature. According to the International Confederation for Thermal Analysis and Calorimetry, thermal analysis is a group of techniques in which a physical property of a substance is measured as a function of temperature whilst the substance is subjected to a controlled temperature program. I.e., in thermal analysis a sample of said substance is subjected to an excitation which generates an observable response. The response signal corresponding to said observable response is measured with measurement means. First data comprising the response signal and the excitation, both as a function of time (i.e., a time series of the excitation and the response signal), is used to calculate a thermoanalytical measurement curve which allows the identification of said thermal effect. In a computer-implemented method for thermal analysis, the first data may be provided to a first software module, said first software module being configured to calculate said measurement curve from the first data. The first software module may be further configured to output second data suitable for representing the measurement curve. I.e., the second data comprises data which allows to represent the curve shape and/or the curve progression of the measurement curve. A graphical representation of the second data respectively the measurement curve may be displayed on display means. A first software module mentioned above is known in the art, e.g., as the STARe Software of Mettler-Toledo.

One example of thermal analysis is Differential Scanning Calorimetry (DSC). In a DSC experiment, a sample of a substance and a known reference, typically an empty crucible, are subjected to an excitation comprising a temperature program. The excitation quantity of the excitation may be in the form of a linear temperature ramp superposed with a periodic temperature modulation having a predetermined frequency and amplitude. This generates an observable response comprising a response quantity which corresponds to a heat flow constituted by a difference between heat flows to the sample and the reference. Said heat flow may be measured, e.g., via a thermoelectric voltage which is the response signal, by using measurement means. The first data comprising the response signal as a function of time and the temperature of said temperature program as a function of time allows to calculate the DSC curve, i.e., the measurement curve. Details regarding DSC may e.g. be found in the standard textbook "Differential Scanning Calorimetry - An Introduction for Practitioners" by G. Höhne, W. Hemminger, H.-J. Flammersheim.

Once the measurement curve is calculated, it may be displayed, e.g., on display means, and may be examined for thermal effects by a human expert. In the case of DSC, such thermal effects may include a glass transition, a cold crystallization or a melting. The thermal effects are reflected in the shape of the corresponding measurement curve, e.g., as a peak, a dip, a step, etc. However, the interpretation of measurement curves and the identification of thermal effects in such curves is a difficult task. Curve analysis and interpretation requires a considerable amount of experience in thermal analysis as well as a knowledge of the possible reactions the particular sample may undergo. Overlapping effects and artefacts make this process even more difficult. Thus, thermal analysis is difficult, cumbersome and error prone.

In the past, electronic data processing has been proven to be a useful tool for the analysis of thermoanalytical measurement curves. DE 10 2013 011 730 B3 discloses a method for evaluating a thermoanalytical measurement curve by using electronic data processing means. The measurement curve is segmented in accordance with characteristic changes present in the measurement curve, and features associated to the thermal effects reflected by these changes are calculated to thereby obtain a feature vector. This feature vector is compared with feature vectors of known substances stored in a database by using an algorithm to thereby obtain a probability of agreement. US 2011/0301860 A1 discloses a computer-implemented method for categorizing DSC plasma thermograms using a similarity metric to identify a pre-characterized inflammatory disease.

There also exist computer-implemented methods for thermal analysis in the art which make use of artificial intelligence. In CN 105823863 A a thermogravimetric measurement curve of coal is first analyzed to extract values of feature points associated with said curve. These values are then used as the input of a neural network which outputs data related to the quality of coal. BRPI 0604102 A uses an expert system to associate molecular fragments to mass losses determined by thermogravimetric analysis. These methods are based on models which leaves room for improvement.

Thus, it is an object of the present invention to provide a computer-implemented method for thermal analysis which is efficient and reliable.

According to a first aspect of the present invention, this object is attained in that the method mentioned above further comprises providing said second data to a second software module, said second software module comprising an artificial intelligence engine configured for automatic identification of thermal effects, said second software module being configured to receive said second data as an input and to output third data representative of said thermal effect automatically identified by said artificial intelligence engine.

The identification of thermal effects in a measurement curve by an artificial intelligence engine according to the first aspect of the present invention is faster and less error prone than an identification carried out by a human expert. Furthermore, it does not require the extraction of values of feature points from a measurement curve, as it is disclosed, e.g., in CN 105823863 A, and is thus also faster and less error prone than known computer-implemented methods which use artificial intelligence.

The method according to the first aspect of the present invention uses a modular approach: The first software module calculates a thermoanalytical measurement curve from the experimental data, i.e. the observable response signal and the excitation, and the second software module identifies the thermal effects reflected in the second data by using artificial intelligence. Such a modular approach is very efficient, as the two software modules may be optimized for their respective tasks. Furthermore, known software modules configured for calculating a thermoanalytical measurement curve, like the STARe software of Mettler-Toledo, may be used as the first software module.

In addition, the first and second software modules communicate with each other via a well-defined data interface - the second data which is the output of the first software module is accepted as an input by the second software module. Thus, it is possible to change components, subroutines, etc. of the first and second software modules without affecting the functioning of the method as long as the data structure of the second data remains unchanged. In this way, the method of the present invention is very flexible. For example, the first software module may be understood as a basic software for thermal analysis. This basic software may comprise several main programs, e.g., an installation program for setting up instruments, creating users and entering data concerning reference materials, a control program representing measurement means or balances and allowing to create methods and experiments for routine operations and a calculation program for calculating said thermoanalytical measurement curve. Reference materials can be used for calibration and adjustments. Said calculation program may be configured to accept said first data as an input and to output said second data. Updates of the different programs of the first software module do not affect the method according to the first aspect of the present invention as long as the data structure of the second data remains unchanged.

The substance analyzed by the method according to the first aspect of the present invention may be any substance, including a pure substance or a mixture. The thermal effect may be any thermal effect and may include an artefact. In the case of an artefact, the third data may comprise the information that the thermal effect is an artefact.

The first data may comprise data obtained by subjecting said sample to a thermoanalytical measurement comprising Differential Scanning Calorimetry (DSC), Differential Thermal Analysis (DTA), Thermogravimetric Analysis (TGA), Evolved Gas Analysis (EGA), Thermomechanical Analysis (TMA) or Dynamic Mechanical Analysis (DMA), but it is not limited to this. The first data may be obtained by applying only one of these measurements, or it may be obtained applying more than one of these measurements sim ultaneously.

The excitation, in particular the excitation as a function of time (i.e., the excitation may be time-dependent), may be known in advance, so that a measurement of its value is not necessary. In another embodiment, the excitation may not be known in advance. Then, measurement means for measuring a value of said excitation, in particular as a function of time, may be provided. For a thermoanalytical measurement, the excitation may comprise an excitation which corresponds to a variable temperature.

The response signal is representative of said thermal effect. There is a functional relationship between the response signal and the observable response. For example, in the case of DSC, the response may comprise a response quantity which corresponds to a heat flow constituted by a difference in heat flows to the sample and a reference, and the response signal may comprise a thermoelectric voltage corresponding to the heat flows. The heat flow may then be calculated from the thermoelectric voltage.

The first data may include data tuples, in particular time-ordered data tuples comprising the excitation, the corresponding response signal at certain instances in time and the respective time.

The first and second software modules are executed by data processing means. The first and second software modules may be executed by the same data processing means, or they may be executed by different data processing means which may be arranged at different locations. The first software module may be installed on a cloud computer. The first software module may be a multi-user application. The first software module may comprise a plurality of first software modules. Each of the plurality of first software modules may be executed by a distinct data processing means, e.g., by a personal computer of one of a plurality of users. The second software module may be executed by a server or a cloud computer which may e.g. be located at the site of a software provider, a user or elsewhere. The first software module may be integrated in a Laboratory Information Management System (LIMS). The first software module may be executed by a data processing means which is part of a measurement means for thermal analysis.

The measurements performed to obtain the first data may be performed by the user of the method according to the first aspect of the present invention. In this case, the method may further comprise subjecting said sample to the excitation which generates the observable response and measuring the corresponding observable response signal of said sample as a function of time. Alternatively, the measurements may be carried out by a third party and the first data may be provided to the user of the method according to the first aspect of the present invention for thermal analysis. The first data representing the observable response signal and the excitation, both as a function of time, is provided to the first software module. The first software module is configured to calculate the thermoanalytical measurement curve from the first data.

The measurement curve calculated by the first software module may be a two-dimensional curve. Such a measurement curve establishes a relationship between a certain excitation or time and a corresponding observable response. E.g., in the case of DSC, the measurement curve may establish a relationship between the temperature or time and the heat flow.

However, the measurement curve may also be multidimensional. The measurement curve may comprise only one multidimensional curve. Alternatively, the measurement curve may comprise more than one two-dimensional curve. In both cases, the measurement curve establishes a relationship between a certain excitation or time and each of a plurality of corresponding observable responses. E.g., in the case of DSC, the measurement curve may establish a relationship between a time, a heat flow, a reference temperature and a sample temperature.

The second data which is the output of the first software module may comprise or be any data representing the shape of said measurement curve. For example, the measurement curve may establish a relationship between the temperature $T_i$ and/or the time $t_i$ and some physical quantity $Q_i$, e.g., the observable response. Then, the second data may comprise a collection of tuples of data point values $(t_i, T_i, Q_i)$. Additionally, or alternatively, the second data may comprise pixel data of a graphical representation of the measurement curve. In the case of DSC, the second data may comprise tuples of data points $(t_i, \Phi_i, T_{s,i}, T_{r,i})$, wherein $t_i$ is the time, $\Phi_i$ is the heat flow, $T_{s,i}$ is the sample temperature and $T_{r,i}$ is the temperature of the reference. The reference may be an empty crucible. The data pairs $(t_i, \Phi_i)$ may represent the DSC curve.

The second data is provided to the second software module. The second software module comprises an artificial intelligence engine configured for automatic identification of thermal effects. The artificial intelligence engine may be operative to detect a characteristic feature of the thermal effect reflected in the second data and/or the measurement curve. The artificial intelligence engine may comprise at least one artificial intelligence algorithm, in particular a machine learning algorithm. A machine learning algorithm may be trained using training data. I. e., the machine learning algorithm may be first trained using training data and then be used for the identification of thermal effects. The machine learning algorithm may comprise a supervised learning algorithm. I.e., the machine learning algorithm may accept training input data, make a prediction based on an underlying model/function and is corrected when those predictions are wrong in view of training output data. In particular, the supervised learning algorithm may comprise a classification algorithm.

The training data may be created in the following way: A known training substance may be subjected to an excitation which generates an observable response and first data comprising the corresponding response signal and the excitation, both as a function of time, is created. The first data is used to calculate a thermoanalytical measurement curve. Then, second training data suitable for representing the shape of the measurement curve, e.g., tuples of data points of the curve, or pixel data of the graphical representation of the measurement curve, is created. Furthermore, the measurement curve and/or the second data is analyzed, e.g. by a human expert, for thermal effects present in the second data and/or the measurement curve. In this way, third training data representative of a thermal training effect reflected in the measurement curve may be determined. The third training data may comprise e.g. the type of the effect and the location of the effect in the measurement curve.

The second and third training data is then used to train an artificial intelligence algorithm, e.g., a machine learning algorithm, of the artificial intelligence engine. An artificial intelligence algorithm template to be trained with training data may be provided. The artificial intelligence algorithm template accepts second data as an input and outputs third data in a way specified by engine parameters. The second training data is provided as an input to the artificial intelligence algorithm template, and the output of the algorithm is compared with the third training data. The engine parameters are then changed until the output of the algorithm is substantially equal to the third training data associated to the second training data. "Substantially equal" means that the distance between the output and the third training data is smaller than some threshold value within some norm. In this way, the artificial intelligence algorithm used in the artificial intelligence engine is trained and may then be deployed to the second software module.

The third data may be any data representative of said thermal effect automatically identified by said artificial intelligence engine. The third data may comprise a confidence value associated with the identified effect.

In one embodiment of the method according to the first aspect of the present invention, said artificial intelligence engine may comprise at least one neural network for said automatic identification of thermal effects, said at least one neural network comprising an input layer of input neurons for receiving said second data and an output layer of output neurons for outputting said third data, and said second data may be provided to the input neurons of said input layer. Then, the third data representative of said thermal effect may be obtained as an output at the output layer of the at least one neural network. In addition, the neural network may comprise one or more hidden layers. Each layer of the neural network comprises a plurality of artificial neurons. The neurons in subsequent layers may be connected by weighted links with adjustable weights. Each neuron receives an input value and produces an output value by applying a nonlinear function to the input value. The output value is transmitted to the neurons in the subsequent intermediate layer or is presented as the output of the neural network at the output layer.

The neurons of the neural network may be sigmoid neurons. A sigmoid neuron may accept N inputs $x_i$ with associated weights $w_i$ and output $\frac{1}{1+exp(-\sum_i w_i x_i - b)}$ wherein b is the so-called bias.

The artificial intelligence engine according to the present invention may comprise one, two, three or more neural networks. In case that there is more than one neural network, the neural networks may differ in their network architecture, e.g., in the number of input and/or output neurons and/or the number of hidden layers and/or the weights and/or the biases and/or the topology. The method of the present invention works for an arbitrary network architecture.

In one embodiment, said artificial intelligence engine may comprise at least two sub engines which are preferably neural networks for said automatic identification of thermal effects, and said second software module may be further configured to receive selection data for selecting one of said sub engines for the automatic identification of thermal effects and to provide the second data to an input of the selected sub engine which is done by providing the second data to the input layer of the selected neural network in the preferred embodiment of the sub engines being neural networks, and said selection data may be provided to said second software module. The at least two sub engines may e.g. be adapted for the identification of thermal effects of substances in different material classes (e.g., metals, polymers, etc.), and the selection data may comprise data associated with said material class. However, there may be also other characteristic properties associated with each of the sub engines, and the selection data may comprise data that allows to select the desired sub engine. For example, in the case that the sub engines are neural networks, they may differ in the type of neurons, the number of layers, the topology, the version number, the type of training data used for the training of the respective neural network, etc. The second data may comprise the selection data. A user may input the selection data into the first and/or second software module. By allowing a selection of one of the sub engines for the automatic identification of thermal effects, the efficiency and accuracy of the method may be improved, as a sub engine best suited for the identification of thermal effects present in a certain substance may be chosen in advance.

In one example of the method according to the first aspect of the present invention said method may further comprise deploying at least one sub engine to said second software module and/or removing at least one sub engine from said second software module and/or deactivating at least one sub engine in said second software module and preferably the sub engine is a neural network. In this way, the artificial intelligence engine may be made user-specific. By deploying at least one sub engine to said second software module, a user-specific sub engine and/or an updated sub engine, etc. may be provided to the second software module and may be used for the automatic evaluation of thermal effects. By removing at least one of the sub engines and then deploying a sub engine or vice versa, a sub engine may be replaced in the artificial intelligence engine. Since there is a well-defined interface between the first and the second software modules, deploying and/or removing and/or deactivating at least one sub engine as mentioned above is possible and does not affect the working principle of the method according to the first aspect of the present invention. Furthermore, it is also possible to change the first software module, e.g., by updates of a calculation routine of the thermal measurement curve or any other routine in the first software module as long as the data structure of the second data is not changed. Thus, the method according to the first aspect of the present invention is very flexible, as the sub engines and the first software module may both be updated or changed without affecting the working principle of the method as long as the data interface between the first and second software modules is not changed.

In another embodiment of the method according to the first aspect of the present invention, said method may further comprise the use of a training software module to create a trained sub engine, which is preferably a trained neural network, and deploying the trained sub engine to said second software module, whereby the training software module is configured to create the trained sub engine by using expert training data associated to at least one training sample of a training substance, said expert training data comprising data sets of second and third training data, said second training data being suitable for representing a training measurement curve due to said training sample, said training measurement curve allowing the identification of at least one thermal training effect due to that training sample, and said third training data being representative of said thermal training effect, and by providing a sub engine template which links an input data to output data in a matter specified by a set of engine parameters and by determining the engine parameters such that, for most of the data sets, the third data outputted by the trained sub engine using the engine parameters is essentially equal to the third training data of one of the data sets when the second training data of said data set is inputted into said trained sub engine, whereby the sub engine template is preferably a blank neural network comprising an input layer for receiving said second data, an output layer for outputting said third data, and preferably one or more intermediate layers and weights describing the connection between the input layer, the output layer and preferably intermediate layer and the engine parameters are preferably weights, which are determined such that, for most of the data sets, the third data outputted by the output layer is essentially equal to the third training data of one of the data sets when the second training data of said data set is received by the input layer and whereby the determined weights specify the trained neural network.

The trained sub engine is created by starting with a sub engine template. Such a template links input data to output data in a matter specified by a set of engine parameters. I.e., there is a functional relationship between the input data and the output data. When the trained sub engine is a trained neural network, the sub engine template is a blank neural network comprising an input layer of input neurons for receiving the second data and an output layer of output neurons for outputting the third data. Furthermore, the blank neural network may comprise one or more intermediate layers of neurons subsequently arranged between the input layer and the output layer. The neurons in subsequent layers are connected by links associated with weights which are engine parameters.

The engine parameters are chosen such that for most of the data sets the third data outputted by the trained sub engine is essentially equal to the third training data of one of the data sets when the second training data of said data set is inputted into said trained sub engine. Here, "essentially equal" may mean that the difference between the third data and the third training data within some norm is smaller than a threshold value.

An optimization routine may be used to choose the engine parameters accordingly. For example, at the beginning of the training the engine parameters may be set to some initial values. These values may, e.g., be chosen randomly. Then, second training data of one of the data sets may be provided as the input data to the sub engine template and the respective output of the sub engine template may be compared with the third training data, e.g., via a distance within some norm. The engine parameters may then be modified such that the output of the sub engine template approximates the third training data to a desired accuracy within said norm. Here, a gradient optimization method may be used.

In case that the sub engine is a neural network, the engine parameters may be weights. Then, these weights may be chosen such that for most of the data sets the third data outputted by the output layer is essentially equal to the third training data of one of the data sets when the second training data of said data set is received by the input layer. Then, the determined weights specify the trained neural network.

The expert training data may comprise data sets of one or more training samples of one particular training substance. Alternatively, the expert training data may comprise data sets of one or more training samples of several different training substances. The training substances may belong to one material class, e.g., polymers, PETs, metals, etc. Then, the trained sub engine may be well suited for the identification of thermal effects due to substances belonging to said material class. Alternatively, the training substances may belong to different material classes.

The trained sub engine may be created from the sub engine template, preferably from the blank neural network, by using expert training data provided by a user. In this way, a user-specific sub engine, preferably a user-specific neural network, may be created. Ways to generate a neural network are disclosed e. g. in US 2021/0012206 A1.

In the case that the artificial intelligence engine comprises more than one sub engine it may be beneficial when said second software module is further configured to receive selection data for selecting one of the sub engines for the automatic identification of thermal effects and to provide the second data to the selected sub engine, and said selection data may be provided to said second software module, as has been explained above. Then, a user may e.g. select the trained sub engine by providing the corresponding selection data to the second software module.

According to one example, said training measurement curve may be obtained by applying a thermoanalytical measurement to said training sample and/or said training measurement curve may be a theoretical measurement curve corresponding to said training sample, and wherein said third training data may be obtained by human identification of the thermal training effect present in said training measurement curve. I.e., measurement curves may be analyzed by a human expert for possible thermal effects and/or theoretical measurement curves containing thermal training effects may be created and analyzed by a human expert, and these measurement curves may be used for the training of the trained sub engine. In one embodiment, measurement curves obtained by a thermoanalytical measurement and a theoretical measurement curve corresponding to said training sample may both be used for training the trained sub engine.

The third data may be any data representative of said thermal effect automatically identified by said artificial intelligence engine. In one example, said third data may comprise an excitation range and a type of said thermal effect. The excitation range may be defined by lower and upper boundary values of the excitation range, and the thermal effect may occur between said lower and upper values. The type of effect may include, e.g., a glass transition, a melting point, and a cold crystallization peak. In case that the thermal effect is an artefact, the third data may comprise this information.

In one embodiment, the method may further comprise providing said third data and fourth data suitable for representing said measurement curve to an evaluation software module, said evaluation software module being configured to receive said third and fourth data as an input and to calculate a value of at least one characteristic quantity associated with said at least one thermal effect in accordance with said fourth data. The fourth data may be provided by the first software module. The fourth data may be equal to or comprise the second data. However, the fourth data may also be different from the second data. E.g., when the second data comprises pixel data representing the measurement curve, the fourth data may comprise tuples of data point values $(t_i, T_i, Q_i)$ of the time $t_i$, the temperature $T_i$ and the physical quantity $Q_i$, as was explained above.

The evaluation software module may be further configured to output said characteristic quantity. The characteristic quantity may be any physical quantity associated with said thermal effect. For example, the third data may comprise the type of the effect and the corresponding excitation range. E.g., in the case of DSC, the characteristic quantity may comprise, depending on the type of the effect, a glass transition temperature, an onset temperature of a thermal effect, a melting point temperature, a peak value, a midpoint temperature, an integral, etc. The first, second and evaluation software modules communicate with each other via well-defined data interfaces - the second data which is the output of the first software module is accepted as an input by the second software module, and the third data which is the output of the second software module and the fourth data is accepted as an input by the evaluation software module. Thus, it is possible to change components, subroutines, etc. of the first, second and evaluation software modules without affecting the functioning of the method as long as the data structures of the second, third and fourth data remain unchanged.

The evaluation software module may be a software module independent of the first and second software modules. However, the evaluation module may also be implemented as a routine within the first software module and the first software module may be further configured to receive said third data as an input.

The method according to the first aspect of the present invention may further comprise displaying a graphical representation of the thermoanalytical measurement curve and/or data associated with the excitation range of the thermal effect and/or data associated with the type of said thermal effect and/or the value of the at least one characteristic quantity on display means. This allows a graphical representation of the results of the thermal analysis.

The excitation may comprise one or more excitation quantities. Said excitation may comprise an excitation quantity which corresponds to a variable temperature. The variable temperature may be a temperature program. Additionally or alternatively, the excitation may comprise an excitation quantity which corresponds to a variable power and/or an excitation quantity which corresponds to a variable pressure and/or an excitation quantity which corresponds to a variable amount of radiation and/or an excitation quantity which corresponds to a variable stress or strain and/or an excitation quantity which corresponds to a variable atmosphere of gas and/or an excitation quantity which corresponds to a variable magnetic field. In this way, thermoanalytical measurements including Differential Scanning Calorimetry (DSC), Differential Thermal analysis (DTA), Thermogravimetric Analysis (TGA), Evolved Gas Analysis (EGA), Thermomechanical Analysis (TMA) or Dynamic Mechanical Analysis (DMA) may be performed. Only one of these measurements may be performed, or more than one of these measurements may be performed simultaneously. When the excitation comprises more than one excitation quantity, more than one thermoanalytic method may be applied simultaneously to the sample.

The response may comprise one or more response quantities. The response may comprise a response quantity which corresponds to a temperature difference of a dynamic thermoanalytical method and/or a response quantity which corresponds to a heat flow of a dynamic thermoanalytical method, in particular a heat flow constituted by a difference between heat flows to a sample of the substance and to a known reference and/or a response quantity which corresponds to a difference in heating power of a dynamic power-compensating thermoanalytical method and/or a response quantity which corresponds to a change in length of a dynamic thermomechanical analytical method and/or a response quantity which corresponds to a change in weight of a dynamic thermo-gravimetric analytical method and/or a response quantity which corresponds to a force of a dynamic mechanical analytical method and/or a response quantity which corresponds to a change in length of a dynamic mechanical analytical method and/or a response quantity which corresponds to a change in voltage of a dynamic dielectric analytical method.

According to a second aspect of the present invention, there is provided a system for thermal analysis of a sample of a substance, said system comprising:

Measurement means, said measurement means being operative to measure a response signal of a sample subjected to an excitation which generates an observable response, said response signal being representative of a thermal effect due to said sample and to output first data representing the response signal and said excitation as a function of time;

Data processing means comprising a first software module, said first software module being configured to receive the first data as an input, to calculate a thermoanalytical measurement curve from the first data, said thermoanalytical measurement curve allowing the identification of said thermal effect and to output second data suitable for representing said measurement curve, wherein said data processing means further comprises a second software module comprising an artificial intelligence engine configured for automatic identification of thermal effects, said second software module being configured to receive said second data as an input and to output third data representative of said thermal effect identified by said artificial intelligence engine.

The method according to the second aspect of the present invention is adapted for implementing the method according to the first aspect of the present invention. Everything that was said above in relation to the method according to the first aspect of the present invention also applies to the system according to the second aspect of the present invention.

The system may comprise one measurement means or a plurality of measurement means. Preferably, a measurement means is a sensor such as a heat flow sensor or a temperature sensor. Each of the plurality of measurement means may be operative to measure a particular type of response signal of a sample subjected to a particular excitation which generates a particular observable response, said particular response signal being representative of a thermal effect due to said sample. For example, one of the measurement means may be operative to implement a DSC measurement, another measurement means may be operative implement a TGA measurement, and so forth. However, the system may also comprise several measurement means which are operative to measure the same type of response signal. Each measurement means of the plurality of measurement means may be in communication with the data processing means and operative to provide first data to the data processing means. The measurement means may comprise a sending unit for sending the first data to the data processing means and the data processing means may comprise a receiving unit for receiving the first data.

The data processing means may be a single data processing means or it may comprise a plurality of data processing means. For example, a first data processing means may be operative to execute the first software module and a second data processing means may be operative to execute the second software module. Furthermore, the first data processing means may comprise a server or cloud computer and may be accessible by several users. In this way, a multi-user environment may be created. In one embodiment, the measurement means may comprise the first data processing means and/or the second data processing means.

According to a third aspect of the present invention there is provided a computer program for thermal analysis of a sample of a substance, said computer program comprising a first software module, said first software module being configured to receive first data representing a response signal of said sample subjected to an excitation which generates an observable response and said excitation as a function of time as an input, said response signal being representative of a thermal effect due to said sample, to calculate a thermoanalytical measurement curve from the first data, said thermoanalytical measurement curve allowing the identification of said thermal effect and to output second data suitable for representing said measurement curve, wherein said computer program further comprises a second software module which comprises an artificial intelligence engine configured for automatic identification of thermal effects, said second software module being configured to receive said second data as an input and to output third data representative of said thermal effect identified by said artificial intelligence engine.

The computer program according to the third aspect of the present invention is adapted to implement the method according to the first aspect of the present invention and is adapted to be used in the system according to the second aspect of the present invention. Everything that was said above in relation to the method according to the first aspect of the present invention and the system according to the second aspect of the present invention also applies to the computer program according to the third aspect of the present invention.

According to a fourth aspect of the present invention there is provided a training software module of a computer program for thermal analysis of a sample of a substance, said training software module being configured to receive expert training data comprising data sets of second and third training data, said second training data being suitable for representing a training measurement curve due to a training sample, said training measurement curve allowing the identification of at least one thermal training effect due to said training sample, and said third training data being representative of said thermal training effect,

and/or to create expert training data by being configured to receive second data suitable for representing a thermoanalytical measurement curve which allows the identification of at least one thermal training effect from a first software module according to the third aspect of the present invention and by being configured to create associated third data from a human input representative of a human identification of the at least one thermal training effect,

whereby the training software module creates a trained sub engine, preferably a trained neutral network, based on the training data, the trained sub engine being suitable to be deployed to the second software module according to the third aspect of the present invention,

whereby the training software module is preferably part of the computer program according to the third aspect of the present invention.

The training software module according to the fourth aspect of the present invention is configured to create a trained sub engine by using expert training data. As was explained above in relation to the method according to the first aspect of the present invention, this trained sub engine may be created by providing a sub engine template which links input data to output data in a matter specified by a set of engine parameters and by determining the engine parameters such that, for most of the data sets, the third data outputted by the trained sub engine using the engine parameters is essentially equal to the third training data of one of the data sets when the second training data of said data set is inputted into said trained sub engine. The trained sub engine may a user-specific sub engine, in particular a user-specific neural network, as was explained above.

In one example, the sub engine template may be a blank neural network comprising an input layer of input neurons for receiving said second data, an output layer of output neurons for outputting said third data, and preferably one or more intermediate layers of neurons. The neurons in different layers may be linked by connections with associated weights, the weights being the engine parameters. The weights are determined such that, for most of the data sets, the third data outputted by the output layer is essentially equal to the third training data of one of the data sets when the second training data of said data set is received by the input layer and whereby the determined weights specify the trained neural network.

The engine parameters may be determined as was explained above in relation to the method according to the first aspect of the present invention.

According to a fifth aspect of the present invention, there is provided a computer-readable data carrier having stored thereon the computer program according to the third aspect of the present invention.

In the following description, the invention will be specified in greater detail by way of examples, with reference to the drawings. In the drawings,

Fig. 1      is a schematic representation of a system according to the second aspect of the present invention,

Fig. 2      illustrates a flow chart of an embodiment of the method according to the first aspect of the present invention,

Fig. 3a     illustrates an example of a DSC measurement curve calculated by the first software module,

Fig. 3b     illustrates the measurement curve shown in Fig. 3a wherein the thermal effects identified by the second software module and associated characteristic quantities calculated by the evaluation module are displayed,

Fig. 4      illustrates a flow chart of training a neural network used in an artificial intelligence engine according to the present invention.

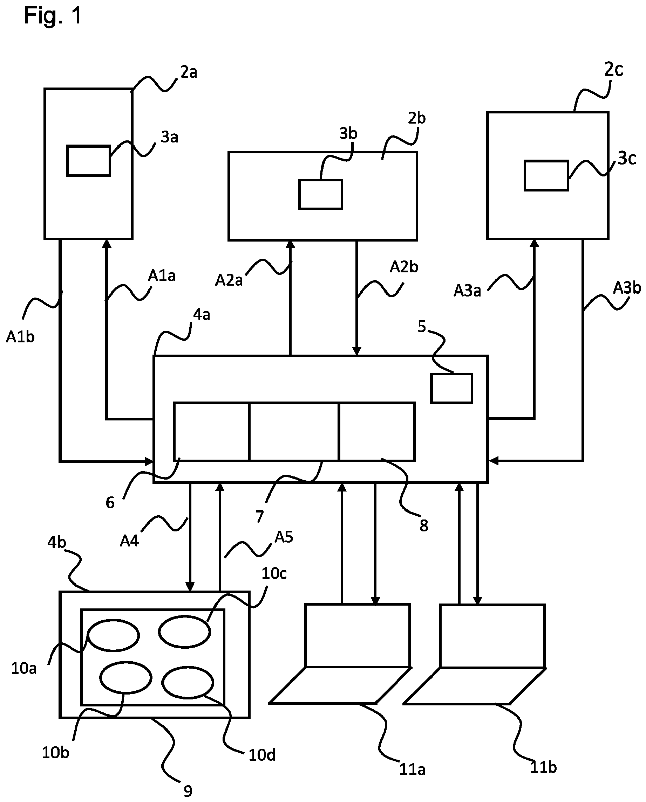

Fig. 1 is a schematic representation of a system 1 according to the second aspect of the present invention. The system comprises three measurement means 2a, 2b, 2c, each of the measurement means 2a, 2b, 2c being operative to measure a response signal of a sample subjected to an excitation which generates an observable response, said response signal being representative of a thermal effect due to said sample. For example, the measurement means 2a may be operative to implement a DSC measurement. Then, the excitation may comprise a variable temperature in the form of a temperature program. The observable response may comprise a heat flow constituted by a difference between heat flows to a sample of the substance and to a known reference, which is typically an empty crucible. The corresponding response signal may be a thermoelectric voltage which is measured by the measurement means 2a. The measurement means 2b may, for example, be operative to implement a TGA measurement, and the measurement means 2c may, for example, be operative to implement a TMA measurement. Alternatively, all three measurement means 2a, 2b, 2c may be operative to implement a DSC measurement. In Fig. 1, each of the measurement means 2a, 2b, 2c implements a thermoanalytic measurement on a respective sample 3a, 3b, 3c. The samples 3a, 3b, 3c may be samples of the same substance or they may be samples of different substances.

Each of the measurement means 2a, 2b, 2c is operative to output first data representing the response signal and said excitation, both as a function of time. For example, in the case of the measurement means 2a configured to implement a DSC measurement, the first data may comprise the thermoelectric voltage representative of the heat flows to the sample 3a and a reference (not shown), a temperature of the sample 3a and a temperature of the reference, all as a function of time. Preferably, the first data is time-ordered.

Each of the measurement means 2a, 2b, 2c may be in communication with data processing means. The data processing means may be accessible by several user PCs 11a, 11b. The data processing means may comprise first data processing means 4a and second data processing means 4b in communication with each other. The first data processing means 4a may comprise a CPU 5 and may be operative to execute a first software module 6, an evaluation software module 7, and optionally, one or more other software modules 8. One of these other software modules may comprise an installation program for setting up instruments, creating users and entering data concerning reference materials. Another one of these software modules may comprise a control program representing measurement means or balances and allowing to create methods and experiments for routine operation. I. e., the first data processing means 4a may send instructions to the measurement means 2a, 2b, 2c (see arrows A1a, A2a, A3a from the first data processing means 4a to the measurement means 2a, 2b ,2c). Alternatively, and not shown in Fig. 1, each measurement means may comprise a first data processing means executing a first software module.

The measurement means 2a, 2b, 2c may be operative to send the respective first data to the first data processing means 4a (see arrows A1b, A2b, A3b). Each of the measurement means 2a, 2b, 2c may comprise a sending unit for sending the first data to the first data processing means 4a. The first data processing means 4a may comprise a receiving unit for receiving the first data. The first software module 6 is configured to receive said first data as an input, to calculate a thermoanalytical measurement curve which allows the identification of said thermal effect and to output second data suitable for representing said measurement curve. For example, in the case of DSC, the measurement curve may comprise the relationship between the temperature of the probe and the heat flow. Second data may comprise data representing this measurement curve. For example, the second data may comprise pairs of data points $(T_S(t_i)$, $\Phi_S(T_S(t_i))$ of the sample temperature Ts(t) and the heat flow $\Phi_S(T_S(t_i))$ as a function of the time-dependent temperature $T_s(t_i)$ of the sample, wherein $t_i$ are points in time, as well as the temperature of the reference, the time $t_i$ and a material class.

The first data processing means 4a may be operative to send the second data to the second data processing means 4b (see arrow A4). The first data processing means 4a may comprise a sending unit for sending the second data to the second data processing means 4b. The second data processing means 4b may comprise a receiving unit for receiving said second data. The second data processing means 4b comprises a second software module. The second software module comprises an artificial intelligence engine 9 configured for automatic identification of thermal effects, said second software module being configured to receive said second data as an input and to output third data representative of said thermal effect identified by said artificial intelligence engine 9.

The artificial intelligence engine 9 may comprise at least one neural network. In Fig. 1, the artificial intelligence engine 9 comprises four neural networks 10a, 10b, 10c, 10d for the identification of thermal effects in a DSC measurement curve, and optionally further neural networks (not shown) for the identification of thermal effects in measurement curves obtained by the same or other thermoanalytical measurements, e.g., TGA and TMA. The four neural networks 10a, 10b, 10c, 10d may be configured for the identification of thermal effects of materials belonging to different material classes. E.g., the first neural network 10a may be configured for the identification of thermal effects in polymers, the second neural network 10b may be configured for the identification of thermal effects in metals, the third neural network 10c may be a neural network for the identification of generic thermal effects and the fourth neural network 10d may be a user-specific neural network further specified below. The second software module is operative to receive the second data as an input and to select one of the neural networks for the automatic identification of thermal effects depending on selection data specifying the material class comprised in the second data. For example, when the selection data is "polymer", the first neural network 10a is selected for the identification of thermal effects. Further, possible selection data for the example of the artificial intelligence engine explained above may specify "metal", "generic" and "user-specific".

Each of the neural networks 10a, 10b, 10c, 10d is configured to accept the second data as an input and to output third data representative of said thermal effect identified by said neural network. The third data may comprise an excitation range and a type of said thermal effect. For example, in the case of DSC, the third data may comprise lower and upper temperature values of a temperature range and a type of said thermal effect, e.g., a glass transition.

The third data is then sent to the evaluation software module 7 executed by the first data processing means 4a (see arrow A5). The second software module may comprise a sending unit for sending the third data to the evaluation software module 7. The first software module may comprise a receiving unit for receiving the third data. The evaluation software module 7 is configured to receive said third data and fourth data suitable for representing said measurement curve as an input and to calculate a value of at least one characteristic quantity associated with said at least one thermal effect in accordance with said fourth data. The evaluation software module 7 may be implemented as a routine within the first software module and the first software module may be further configured to receive said third data as an input. For example, in case of DSC, third data may comprise an identified thermal effect specified by "glass transition" and lower and upper temperature values of a range where this effect occurs, and the evaluation software module 7 may be configured to calculate an onset temperature and a midpoint temperature of the glass transition as the characteristic quantities.

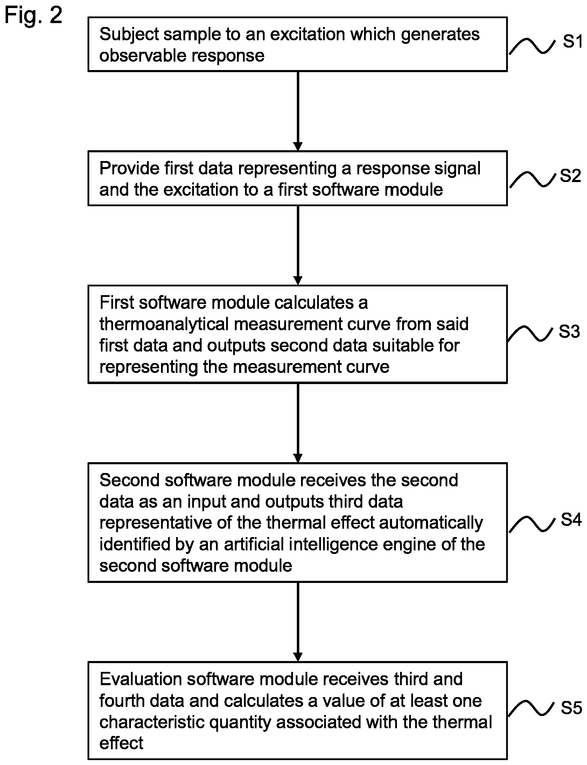

Fig. 2 illustrates a flow chart of an embodiment of the method according to the first aspect of the present invention. In step S1, a sample of the substance is subjected to an excitation which generates an observable response. The corresponding response signal is representative of a thermal effect due to said sample. In the case of DSC, a sample of the substance and a reference are subjected to a temperature program. This generates an observable response, namely a heat flow constituted by a difference between heat flows to the sample and the reference. In a DSC measurement, the heat flow is measured via a thermoelectric voltage which is the response signal. The heat flow is proportional to said thermoelectric voltage. In this way, first data comprising the excitation and the response signal, both as a function of time, is obtained. I.e. for a DSC measurement, the first data may comprise time ordered data comprising for a time $t_i$ a temperature $T_i$ and a thermoelectric voltage $V_i$.

In step S2, the first data is provided to a first software module. The first software module is executed by data processing means, e.g., by the first data processing means 4a shown in Fig. 1.

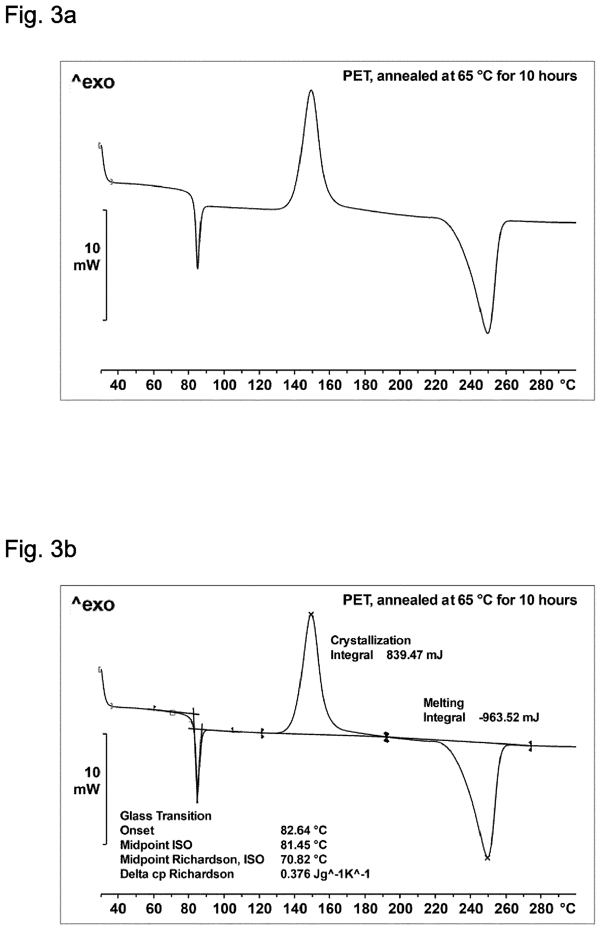

In step S3, the first software module receives said first data as an input and calculates a thermoelectric measurement curve which allows the identification of said thermal effect from said first data. For example, in the case of DSC, the measurement curve represents the relationship between temperature or time and the heat flow. In Fig. 3a a graphical representation of a DSC curve (temperature on the x-axis, heat flow on the y-axis) calculated from first data obtained for a PET sample is depicted. The sample is heated from 30°C to 290°C. In this temperature range, three characteristic changes are visible: a step, a peak and a dip. Each of these characteristic changes corresponds to a thermal effect. The first software module outputs second data suitable for representing the measurement curve. For example, the second data may comprise pairs of data point $(x_i, y_i)$ of the x- and y-values of the measurement curve. Alternatively, the second data may comprise pixel data of a graphical representation of the measurement curve.

In step S4, a second software module receives the second data. The second software module comprises an artificial intelligence engine configured for automatic identification of thermal effects. The artificial intelligence engine may comprise at least one neural network, as was explained above with reference to Fig. 1. The second software module is configured to receive the second data as an input and to output third data representative of said thermal effect automatically identified by said artificial intelligence engine. The third data may comprise an excitation range and a type of the associated thermal effect. For example, for the measurement curve depicted in Fig. 3a, the third data may comprise the following information: glass transition in the temperature range [70°C, 100°C], crystallization in the temperature range [120°C, 180°C], melting in the temperature range [210°C, 270°C].

Figures 3a and 3b show, as an example, the measurement curve and the representation of the identified thermal effects together with the associated, calculated characteristic quantities for the example of PET, annealed at 65°C for 10 hours. A small arrow indicates the direction along the vertical axis which represents an exothermic behavior of the sample. In Figures 3a and 3b the arrow points upwards and indicates thereby that a rising curve describes a process where energy is provided from the sample to its surrounding. Such an exothermal processes of the sample are many chemical reactions or, in the case at hand, a crystallization. Endothermal processes, where the sample consumes energy from the surrounding, for example melting or the glass transition in the illustrated case, appear as sloping curve.

In step S5, an evaluation software module receives said third data and fourth data suitable for representing said measurement curve. The fourth data may comprise pairs of data points $(x_i, y_i)$ of x- and y-values of the measurement curve. The evaluation software module is configured to receive said third and fourth data as an input and to calculate a value of at least one characteristic quantity associated with said at least one thermal effect in accordance with said fourth data. The result of this calculation may be displayed, e.g., in combination with the measurement curve, on display means. An example of such a representation is shown in Fig. 3b. There, the three characteristic changes in the measurement curve are identified as and labeled with "Glass Transition", "Crystallization" and "Melting". For the Glass Transition, the following characteristic quantities are calculated: onset temperature ("Onset"), midpoint temperature according to ISO 11357-2, third edition, published in the year 2020, ("Midpoint ISO"), midpoint temperature according to Richardson ("Midpoint Richardson"), step height of the glass transition according to Richardson ("Delta cp Richardson"). For the crystallization, the integral describing the peak area between the measured curve and a baseline in the range of the crystallization is calculated. For the melting, the integral describing the peak area between the measured curve and a baseline in the range of the melting is calculated.

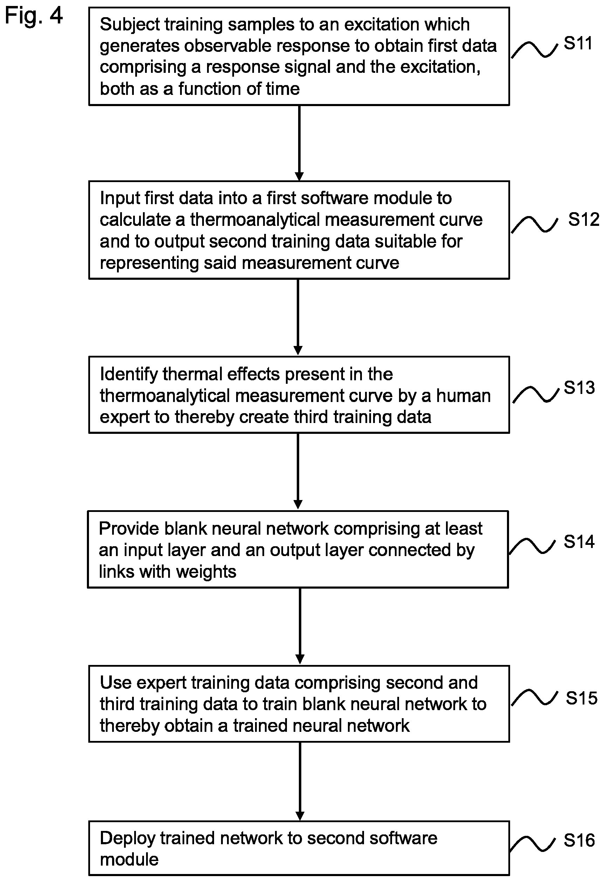

Fig. 4 depicts a flow chart of training a neural network according to the present invention. In the first step, S11, a thermoanalytical measurement is implemented on training samples. I.e., the training samples are subjected to an excitation which generates an observable response. For example, in the case of DSC, a sample of a material and a reference, such as an empty crucible, are subjected to a temperature program. This results in an observable response in the form of a heat flow constituted by a difference between heat flows to the sample and the reference. In a DSC measurement, the heat flow may be measured via a thermoelectric voltage which is the response signal. In this way, first data comprising the excitation and the response signal, both as a function of time, may be obtained.

In step S12, the first data is input into a first software module to calculate a thermoanalytical measurement curve, e.g., a DSC curve, from said first data and to output second training data suitable for representing said measurement curve. The thermoanalytical measurement curve allows to identify thermal effects present in the sample. The second data may, e.g., comprise pairs of data points $(x_i, y_i)$ of x- and y-values of the measurement curve.

In step S13, a human expert identifies the thermal effects present in the thermoanalytical measurement curve. For example, the thermoanalytical measurement curve obtained with the first software module may be displayed on display means. A human expert may identify the location and the type of thermal effects reflected in the measurement curve. In this way, third training data being representative of said thermal effects, and comprising for example, the type and the location of the thermal effects reflected in the measurement curve, may be obtained.

In step 14, a blank neural network comprising at least an input layer of input neurons and an output layer of output neurons connected by links with weights is provided. The neural network may further comprise one or more intermediate layers of neurons subsequently arranged between the input layer and the output layer. The input layer accepts second data as an input and outputs third data.

In step S15, the blank neural network is trained using expert training data comprising the second and third training data. To this end, the weights of the neural network are set to some initial values. Then, the second training data is provided to the input layer of the neural network and third data is obtained at the output layer of the neural network. The third data is compared with the third training data, and the weights are adjusted until the third data is essentially equal to the third training data. A gradient optimization method may be used for adjusting the weights, as it is known in the art. In this way, a trained neural network is generated.

In step S16, the trained neural network is deployed to a second software module comprising an artificial intelligence engine. The second software module may be used for the method, system and computer program according to the present invention.

**Claims**

1. A computer-implemented method for thermal analysis of a sample of a substance, said method comprising: providing first data to a first software module (6), said first data representing an observable response signal of said sample subjected to an excitation which generates an observable response and said excitation as a function of time, said response signal being representative of a thermal effect due to said sample, said first software module (6) being configured to receive said first data as an input, to calculate a thermoanalytical measurement curve from the first data, said thermoanalytical measurement curve allowing the identification of said thermal effect and to output second data suitable for representing said measurement curve **characterized in that** the method further comprises providing said second data to a second software module, said second software module comprising an artificial intelligence engine (9) configured for automatic identification of thermal effects, said second software module being configured to receive said second data as an input and to output third data representative of said thermal effect automatically identified by said artificial intelligence engine (9).

2. Method according to claim 1, wherein said artificial intelligence engine (9) comprises at least one neural network (10a, 10b, 10c, 10d) for said automatic identification of thermal effects, said at least one neural network (10a, 10b, 10c, 10d) comprising an input layer of input neurons for receiving said second data and an output layer of output neurons for outputting said third data, and wherein said second data is provided to said input layer.

3. Method according to claim 1 or 2, wherein said artificial intelligence engine (9) comprises at least two sub engines (10a, 10b, 10c, 10d), which are preferably neural networks (10a, 10b, 10c, 10d), for said automatic identification of thermal effects, wherein said second software module is further configured to receive selection data for selecting one of said sub engines for the automatic identification of thermal effects and to provide the second data to an input of the selected sub engine (10a, 10b, 10c, 10d), which is done by providing the second data to the input layer of the selected neural network (10a, 10b, 10c, 10d) in the preferred embodiment of the sub engines (10a, 10b, 10c, 10d) being neural networks (10a, 10b, 10c, 10d), and wherein said selection data is provided to said second software module.

4. Method according to claim 2 or 3, wherein said method further comprises deploying at least one sub engine to said second software module and/or removing at least one sub engine from said second software module and/or deactivating at least one sub engine in said second software module, and preferably the sub engine is a neural network.

5. Method according to any one of claims 1 to 4, wherein said method further comprises the use of a training software module to create a trained sub engine, which is preferably a trained neural network, and deploying the trained sub engine to said second software module, whereby

the training software module is configured to create the trained sub engine
by using expert training data associated to at least one training sample of a training substance, said expert training data comprising datasets of second and third training data, said second training data being suitable for representing a training measurement curve due to said training sample, said training measurement curve allowing the identification of at least one thermal training effect due to that training sample, and said third training data being representative of said thermal training effect, and

by providing a sub engine template which links an input data to output data in a matter specified by a set of engine parameters, and

by determining the engine parameters such that, for most of the data sets, the third data outputted by the trained sub engine using the engine parameters is essentially equal to the third training data of one of the data sets when the second training data of said data set is inputted into said trained sub engine,

whereby the sub engine template is preferably a blank neural network comprising an input layer for receiving said second data, an output layer for outputting said third data, and preferably one or more intermediate layers and weights describing the connection between the input layer, the output layer and preferably intermediate layer,

and the engine parameters are preferably weights, which are determined such that, for most of the data sets, the third data outputted by the output layer is essentially equal to the third training data of one of the data sets when the second training data of said data set is received by the input layer and whereby the determined weights specify the trained neural network.

**6.** Method according to claim 5, wherein said training measurement curve is obtained by applying a thermoanalytical measurement to said training sample and/or said training measurement curve is a theoretical measurement curve corresponding to said training sample, and wherein said third training data is obtained by human identification of the thermal training effect present in said training measurement curve.

**7.** Method according to anyone of the preceding claims, wherein said third data comprises an excitation range and a type of said thermal effect.

**8.** Method according to anyone of the preceding claims, wherein the method further comprises providing said third data and fourth data suitable for representing said measurement curve to an evaluation software module, said evaluation software module being configured to receive said third and fourth data as an input and to calculate a value of at least one characteristic quantity associated with said at least one thermal effect in accordance with said fourth data.

**9.** Method according to anyone of the preceding claims, wherein the method further comprises displaying a graphical representation of the thermoanalytical measurement curve and/or data associated with the excitation range of the thermal effect and/or data associated with the type of said thermal effect and/or the value of the at least one characteristic quantity on display means.

**10.** Method according to anyone of the preceding claims, wherein said excitation comprises an excitation quantity which corresponds to a variable temperature and/or an excitation quantity which corresponds to a variable power and/or an excitation quantity which corresponds to a variable pressure and/or an excitation quantity which corresponds to a variable amount of radiation and/or a an excitation quantity which corresponds to a variable stress or strain and/or an excitation quantity which corresponds to a variable atmosphere of gas and/or an excitation quantity which corresponds to a variable magnetic field.

**11.** Method according to anyone of the preceding claims, wherein the response comprises a response quantity which corresponds to a temperature difference of a dynamic thermoanalytical method and/or a response quantity which corresponds to a heat flow of a dynamic thermoanalytical method, in particular a heat flow constituted by a difference between heat flows to a sample of the substance and to a known reference and/or a response quantity which corresponds to a difference in heating power of a dynamic power-compensating thermoanalytical method and/or a response quantity which corresponds to a change in length of a dynamic thermo-mechanical analytical method and/or a response quantity which corresponds to a change in weight of a dynamic thermo-gravimetric analytical method and/or a response quantity which corresponds to a force of a dynamic mechanical analytical method and/or a response quantity which corresponds to a change in length of a dynamic mechanical analytical method and/or a response quantity which corresponds to a change in voltage of a dynamic dielectric analytical method.

**12.** A system (1) for thermal analysis of a sample (3a, 3b, 3c) of a substance, said system (1) comprising:

Measurement means (2a, 2b, 2c), said measurement means (2a, 2b, 2c) being operative to measure a response signal of a sample subjected to an excitation which generates an observable response, said response signal being representative of a thermal effect due to said sample and to output first data representing the response signal and said excitation as a function of time;

Data processing means (4a, 4b) comprising a first software module (6), said first software module (6) being configured to receive the first data as an input, to calculate a thermoanalytical measurement curve from said first data, said thermoanalytical measurement curve allowing the identification of said thermal effect and to output second data suitable for representing said measurement curve, **characterized in that** said data processing means (4a, 4b) further comprises a second software module comprising an artificial intelligence engine (9) configured for automatic identification of thermal effects, said second software module being configured to receive said second data as an input and to output third data representative of said thermal effect identified by said artificial intelligence engine (9).

13. A computer program for thermal analysis of a sample of a substance, said computer program comprising a first software module (6), said first software module (6) being configured to receive first data representing a response signal of said sample subjected to an excitation which generates an observable response and said excitation as a function of time as an input, said response signal being representative of a thermal effect due to said sample, to calculate a thermoanalytical measurement curve which allows the identification of said thermal effect and to output second data suitable for representing said measurement curve, **characterized in that** said computer program further comprises a second software module which comprises an artificial intelligence engine (9) configured for automatic identification of thermal effects, said second software module being configured to receive said second data as an input and to output third data representative of said thermal effect identified by said artificial intelligence engine (9).

14. Training software module of a computer program for thermal analysis of a sample of a substance, being configured to receive expert training data comprising data sets of second and third training data, said second training data being suitable for representing a training measurement curve due to a training sample, said training measurement curve allowing the identification of at least one thermal training effect due to said training sample, and said third training data being representative of said thermal training effect,

and/or to create said expert training data by being configured to receive second data suitable for representing a thermoanalytical measurement curve which allows the identification of at least one thermal training effect from a first software module according to claim 13 and by being configured to create associated third data from a human input representative of a human identification of the at least one thermal training effect,

whereby the training software module creates a trained sub engine, preferably a trained neutral network, based on the training data, the trained sub engine being suitable to be deployed to the second software module according to claim 13, whereby the training software module is preferably part of the computer program according to claim 13.

15. A computer-readable data carrier having stored thereon the com puter program of claim 13.

Fig. 1

Fig. 2

| | |
|---|---|
| Subject sample to an excitation which generates observable response | S1 |
| Provide first data representing a response signal and the excitation to a first software module | S2 |
| First software module calculates a thermoanalytical measurement curve from said first data and outputs second data suitable for representing the measurement curve | S3 |
| Second software module receives the second data as an input and outputs third data representative of the thermal effect automatically identified by an artificial intelligence engine of the second software module | S4 |
| Evaluation software module receives third and fourth data and calculates a value of at least one characteristic quantity associated with the thermal effect | S5 |

## Fig. 3a

PET, annealed at 65 °C for 10 hours

## Fig. 3b

PET, annealed at 65 °C for 10 hours

Crystallization
Integral    839.47 mJ

Melting
Integral    -963.52 mJ

Glass Transition
Onset                                82.64 °C
Midpoint ISO                         81.45 °C
Midpoint Richardson, ISO             70.82 °C
Delta cp Richardson                  0.376 Jg^-1K^-1

Fig. 4

Subject training samples to an excitation which generates observable response to obtain first data comprising a response signal and the excitation, both as a function of time ~~ S11

Input first data into a first software module to calculate a thermoanalytical measurement curve and to output second training data suitable for representing said measurement curve ~~ S12

Identify thermal effects present in the thermoanalytical measurement curve by a human expert to thereby create third training data ~~ S13

Provide blank neural network comprising at least an input layer and an output layer connected by links with weights ~~ S14

Use expert training data comprising second and third training data to train blank neural network to thereby obtain a trained neural network ~~ S15

Deploy trained network to second software module ~~ S16

Europäisches
Patentamt

European
Patent Office

Office européen
des brevets

# EUROPEAN SEARCH REPORT

**Application Number**

EP 22 15 0763

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | CN 105 823 863 A (NORTH CHINA ELECTRIC POWER UNIV) 3 August 2016 (2016-08-03) * paragraph [0009] – paragraph [0018]; figures 3, 4 * * paragraph [0034] – paragraph [0036] * | 1-15 | INV. G01N25/00 |
| X | CN 113 760 660 A (UNIV NANJING) 7 December 2021 (2021-12-07) * figures 2-5 * * paragraph [0009] – paragraph [0063] * | 1-15 | |

TECHNICAL FIELDS
SEARCHED       (IPC)

G01N

The present search report has been drawn up for all claims

| Place of search | Date of completion of the search | Examiner |
|---|---|---|
| The Hague | 17 June 2022 | Stavroulakis, E |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

                                        
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 22 15 0763

This annex lists the patent family members relating to the patent documents cited in the above-mentioned European search report.
The members are as contained in the European Patent Office EDP file on
The European Patent Office is in no way liable for these particulars which are merely given for the purpose of information.

17-06-2022

| Patent document cited in search report | | Publication date | Patent family member(s) | Publication date |
|---|---|---|---|---|
| CN 105823863 | A | 03-08-2016 | NONE | |
| CN 113760660 | A | 07-12-2021 | NONE | |

EPO FORM P0459

For more details about this annex : see Official Journal of the European Patent Office, No. 12/82

**EP 4 209 781 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 102013011730 B3
- US 20110301860 A1
- CN 105823863 A
- US 20210012206 A1